# EUROPEAN PATENT APPLICATION

(11) **EP 4 746 682 A1**
(43) Date of publication of application: **20.05.2026**
(21) Application number: 24909851.8
(22) Date of filing: 16.08.2024
(51) Int. Cl.: H10W 90/00

(54) **BACK CONTACT BATTERY CELL, BATTERY MODULE AND PHOTOVOLTAIC SYSTEM**

(30) Priority: 25.12.2023 CN 202311800686; 25.12.2023 CN 202323550299 U
(71) Applicant: Zhuhai Fushan Aiko Solar Energy Technology Co., Ltd., FushanIndustrial Park, Doumen District Zhuhai Guangdong 519000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Zhejiang Aiko Solar Energy Technology Co., Ltd., Yiwu, Jinhua Zhejiang 322000 (CN); Shenzhen Aiko Digital Energy Technology Co., Ltd., Shenzhen, Guangdong 518000 (CN)
(72) Inventor: WANG, Yong, Zhuhai, Guangdong 519000 (CN); WANG, Yongqian, Zhuhai, Guangdong 519000 (CN); TAN, Lixiang, Zhuhai, Guangdong 519000 (CN); HE, Daneng, Zhuhai, Guangdong 519000 (CN); CHEN, Gang, Zhuhai, Guangdong 519000 (CN)
(74) Representative: EP&C
(86) International application number: PCT/CN2024/112772
(87) International publication number: WO 2025/138900

(57) **Abstract**

The present application is applicable to the field of solar cell technology, and provides a back-contact cell, a cell assembly, and a photovoltaic system. The back-contact cell includes a silicon wafer and a plurality of electrode structures, a first electrode region, a second electrode region, and a non-electrode region are formed on a back surface of the silicon wafer, where the non-electrode region is located between the first electrode region and the second electrode region, an electrode structure located in the first electrode region includes a first boundary grid line, an electrode structure located in the second electrode region includes a second boundary grid line, the first boundary grid line and the second boundary grid line have opposite polarities, and disconnection rates of both the first boundary grid line and the second boundary grid line are less than or equal to 5%. In this way, a potential difference of the non-electrode region can be kept as low as possible, so that, without physically cutting the non-electrode region, regions on two sides of the non-electrode region independently operate in a state of sliced cells, thereby achieving an effect identical to that of physically cutting the non-electrode region.

## Description

### Cross-Reference to Related Application

The present application claims priority to Chinese Patent Application No. 2023118006868, filed with the China National Intellectual Property Administration on December 25, 2023 and entitled "Back-Contact Cell, Cell Assembly, and Photovoltaic System", and to Chinese Patent Application No. 2023235502991, filed with the China National Intellectual Property Administration on December 25, 2023 and entitled "Back-Contact Cell, Cell Assembly, and Photovoltaic System", which are incorporated herein by reference in their entireties.

### Technical Field

The present application belongs to the field of solar cell technology, and in particular, relates to a back-contact cell, a cell assembly, and a photovoltaic system.

### Background

Solar cell power generation is a sustainable and clean energy source, which converts sunlight into electrical energy using the photovoltaic effect of a semiconductor p-n junction. A solar cell in which grid lines of two polarities are both formed on the back of the cell is a back-contact cell.

In related technologies, it is usually necessary to cut an entire back-contact cell into a plurality of cells, and then electrically connect the plurality of cells. However, such a slicing step is relatively cumbersome, and a device needs to be provided for the slicing step, resulting in relatively high costs.

### Technical Problem

Based on this, how to design a back-contact cell to reduce costs has become an urgent problem to be resolved.

### Technical Solution

The present application provides a back-contact cell, a cell assembly, and a photovoltaic system, which are intended to solve the problem of how to design a back-contact cell so as to reduce costs.

The back-contact cell provided by the present application includes a silicon wafer and a plurality of electrode structures, a first electrode region, a second electrode region, and a non-electrode region are formed on a back surface of the silicon wafer, where the non-electrode region is located between the first electrode region and the second electrode region, an electrode structure located in the first electrode region includes a first boundary grid line, an electrode structure located in the second electrode region includes a second boundary grid line, the first boundary grid line and the second boundary grid line have opposite polarities, and disconnection rates of both the first boundary grid line and the second boundary grid line are less than or equal to 5%.

The cell assembly provided by the present application includes the back-contact cell according to any of the above items.

The photovoltaic system provided by the present application includes the cell assembly according to any one of the above items.

### Beneficial Effects

The back-contact cell, the cell assembly, and the photovoltaic system according to the embodiments of the present application, since boundary grid lines of two electrode structures have opposite polarities and disconnection rates of the two electrode structures are both less than or equal to 5%, can enable a potential difference of a non-electrode region to be as low as possible. Accordingly, without physically cutting the non-electrode region, regions on two sides of the non-electrode region can independently operate in a state close to that of sliced cells, thereby achieving an effect similar to that of physically cutting the non-electrode region. In this way, an effect similar to slicing is achieved, and the slicing step and slicing device can be omitted, thereby reducing costs.

### Brief Description of the Drawings

FIG. 1 is a schematic diagram of a structure of a back-contact cell according to an embodiment of the present application;
FIG. 2 is an enlarged schematic diagram of part A of the back-contact cell shown in FIG. 1;
FIG. 3 is a schematic diagram of a structure of a back-contact cell according to another embodiment of the present application;
FIG. 4 is an enlarged schematic diagram of part B of the back-contact cell shown in FIG. 3;
FIG. 5 is a schematic diagram of the structure of a back-contact cell according to yet another embodiment of the present application;
FIG. 6 is an enlarged schematic diagram of part C of the back-contact cell shown in FIG. 5;
FIG. 7 is a schematic diagram of a partial structure of a back-contact cell according to an embodiment of the present application;
FIG. 8 is a schematic diagram of a partial structure of a back-contact cell according to another embodiment of the present application; and
FIG. 9 is a schematic diagram illustrating the connection of two adjacent back-contact cells according to an embodiment of the present application.

Description of main reference numerals:
100. back-contact cell, 10. silicon wafer, 11. first electrode region, 12. second electrode region, 13. non-electrode region, 21. first boundary grid line, 22. second boundary grid line, 231. first finger, 232. second finger, 241. first busbar, 242. second busbar, d. width of the non-electrode region, 30. conductive member, 40. pad, and 200. electrical connecting member.

### Detailed Description of the Embodiments

To make the object, technical solutions, and advantages of the present application clearer, the present application will be further described in detail with reference to the accompanying drawings and embodiments. The examples of the embodiments are shown in the accompanying drawings, where the same or similar labels throughout represent the same or similar elements or the elements with the same or similar functions. The embodiments described below with reference to the accompanying drawings are exemplary, and are only intended to explain the present application and cannot be understood as limiting the present application. In addition, it should be understood that the specific embodiments described here are intended for illustrating rather than limiting the present application.

In the description of the present application, it should be understood that, the terms "length", "width", "up", "down", "left", "right", "horizontal", "top", and "bottom" indicate the orientation or position relationship based on the orientation or position relationship shown in the accompanying drawings, only for the convenience of simple description of the present application, rather than indicating or implying that the devices or elements referred to must have a specific orientation, be constructed and operated in a specific orientation, and therefore cannot be understood as a limitation on the present application.

In addition, the terms like "first" and "second" are only for illustrative purposes and cannot be understood as indicating or implying relative importance or the number of technical features referred to. Therefore, the features defined with "first" and "second" may explicitly or implicitly include at least one or a plurality of features. In the description of the present application, the meanings of "a plurality of" refer to two or more, unless otherwise specified.

In the description of the present application, it should be noted that unless otherwise specified and limited, the terms "installation", "connected", and "connection" should be broadly understood, for example, they may be fixed connection, detachable connection, or integrated connection, and may be mechanical connection, also be electrical connection, or mutual communication, direct connection or indirect connection through an intermediate medium, and may also be the internal connection or interaction relationship between two components. Those of ordinary skill in the art can, based on specific circumstances, understand the specific meanings of the above terms in the present application.

In this application, unless otherwise specified and limited, the first feature "above" or "below" the second feature may include direct contact between the first and second features, or direct contact between the first and second features through additional features between them. Moreover, the first feature "over", "above" and "on" the second feature includes the first feature being directly above and diagonally above the second feature, or simply indicating that the first feature is horizontally higher than the second feature. The first feature "below", "beneath", and "under" the second feature includes the first feature directly below and diagonally below the second feature, or simply indicates that the horizontal height of the first feature is less than that of the second feature.

The following disclosure provides many different embodiments, or examples, to implement different features in the present application. The components and arrangements of specific examples are described below to simplify the disclosure of the present application. These are, of course, merely examples and are not intended to limit the present application. In addition, the present application may repeat reference numerals and/or letters in the various examples. This repetition is for the purpose of simplicity and clarity and does not in itself dictate a relationship between the various embodiments and/or configurations discussed. In addition, the present application provides examples of various specific processes and materials, but those of ordinary skill in the art can be aware of the present application of other processes and/or the usage scenarios of other materials.

According to the present application, since the boundary grid lines of the two electrode structures have opposite polarities and disconnection rates of the two electrode structures are less than or equal to 5%, a potential difference of the non-electrode region can be kept as low as possible. Accordingly, without physically cutting the non-electrode region, regions on two sides of the non-electrode region can independently operate in a state close to that of sliced cells, thereby achieving an effect similar to that of physically cutting the non-electrode region. In this way, an effect similar to slicing is achieved, and the slicing step and slicing device can be omitted, thereby reducing costs.

### Embodiment 1

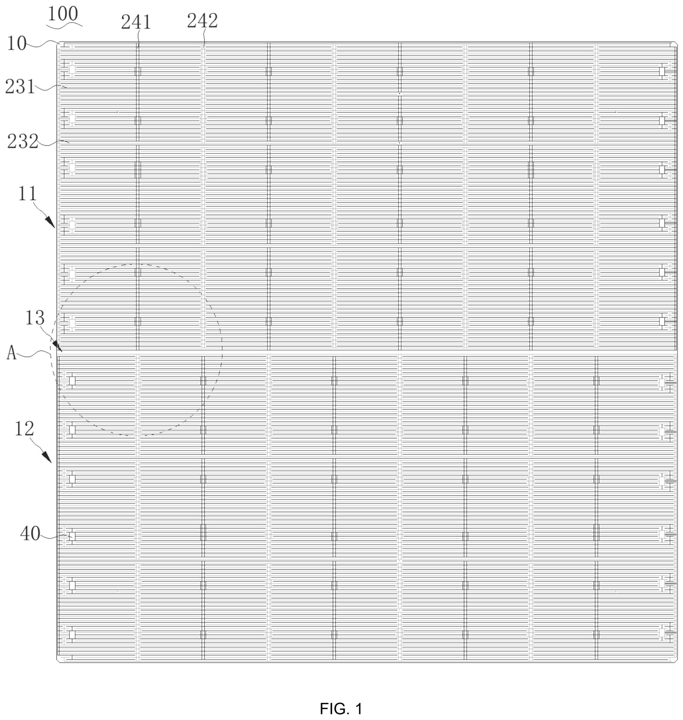

Referring to FIGS. 1, 2, 3, 4, 5, and 6, the back-contact cell 100 according to the embodiment of the present application includes a silicon wafer 10 and a plurality of electrode structures, a first electrode region 11, a second electrode region 12, and a non-electrode region 13 are formed on a back surface of the silicon wafer 10, where the non-electrode region 13 is located between the first electrode region 11 and the second electrode region 12, an electrode structure located in the first electrode region 11 includes a first boundary grid line 21, an electrode structure located in the second electrode region 12 includes a second boundary grid line 22, the first boundary grid line 21 and the second boundary grid line 22 have opposite polarities, and disconnection rates of both the first boundary grid line 21 and the second boundary grid line 22 are less than or equal to 5%.

The back-contact cell 100 according to the embodiment of the present application, since boundary grid lines of two electrode structures have opposite polarities and disconnection rates of the two electrode structures are both less than or equal to 5%, can enable the potential difference of the non-electrode region 13 to be as low as possible. Accordingly, without physically cutting the non-electrode region 13, regions on two sides of the non-electrode region 13 can independently operate in a state close to that of sliced cells, thereby achieving an effect similar to that of physically cutting the non-electrode region 13. In this way, an effect similar to slicing is achieved, and the slicing step and slicing device can be omitted, thereby reducing costs.

It can be understood that, in a case where the first boundary grid line 21 and the second boundary grid line 22 have opposite polarities and excessively large disconnection rates, a large amount of finger current cannot be intercepted at disconnection portions of the boundary grid lines. This results in increased leakage and prevents the potential difference from being reduced as much as possible. As a result, the regions on two sides of the non-electrode region 13 can only operate independently by physically slicing the non-electrode region 13. Even if the disconnection rates of both the first boundary grid line 21 and the second boundary grid line 22 are less than or equal to 5%, and the polarities of the first boundary grid line 21 and the second boundary grid line 22 are not opposite, carriers from one of the boundary grid lines can travel across the surface of the silicon wafer 10 through the non-electrode region 13 directly to the other boundary grid line without passing through the PN junction inside the silicon wafer 10. This causes severe leakage, and the regions on two sides of the non-electrode region 13 can again only operate independently by physically slicing the non-electrode region 13.

In the present application, the first boundary grid line 21 and the second boundary grid line 22 have opposite polarities, and disconnection rates of the two boundary grid lines are less than or equal to 5%. As a result, the disconnection portions of the boundary grid lines can intercept most or even all of the current from the fingers. In addition, carriers from one of the two boundary grid lines do not need to travel across the surface of the silicon wafer 10 through the non-electrode region 13 to reach the other boundary grid line, and the carriers pass through the PN junction inside the silicon wafer 10. In this way, the risk of leakage can be reduced, and the potential difference can be kept as low as possible, even approaching zero. The regions on two sides of the non-electrode region 13 can operate independently without physically slicing the non-electrode region 13.

Optionally, the silicon wafer 10 includes a light-receiving surface and a back surface opposite to each other, and a first electrode region 11, a second electrode region 12, and a non-electrode region 13 are formed on the back surface. Electrode structures are provided in both the first electrode region 11 and the second electrode region 12, and no electrode structures are provided in the non-electrode region 13.

Optionally, one, two, three, or other numbers of the first electrode regions 11 may be provided. The plurality of first electrode regions 11 may have the same or different sizes. The electrode structures in the plurality of first electrode regions 11 may be the same or different. One, two, three, or other numbers of the second electrode regions 12 may be provided. The plurality of second electrode regions 12 may have the same or different sizes. The electrode structures in the plurality of second electrode regions 12 may be the same or different. One, two, three, or other numbers of the non-electrode regions 13 may be provided. The plurality of non-electrode regions 13 may have the same or different sizes. The number of, and the quantitative relationship or size relationship among the first electrode region 11, the second electrode region 12, and the non-electrode region 13 are not limited herein.

Optionally, the non-electrode region 13 is located between the first electrode region 11 and the second electrode region 12. In other words, the first electrode region 11 and the second electrode region 12 are respectively located on two sides of the non-electrode region 13 and are separated by the non-electrode region 13.

Optionally, the first boundary grid line 21 refers to a grid line of the electrode structure in the first electrode region 11 closest to the non-electrode region 13. In other words, the first boundary grid line 21 is a boundary line of the first electrode region 11 and also a boundary line between the first electrode region 11 and the non-electrode region 13.

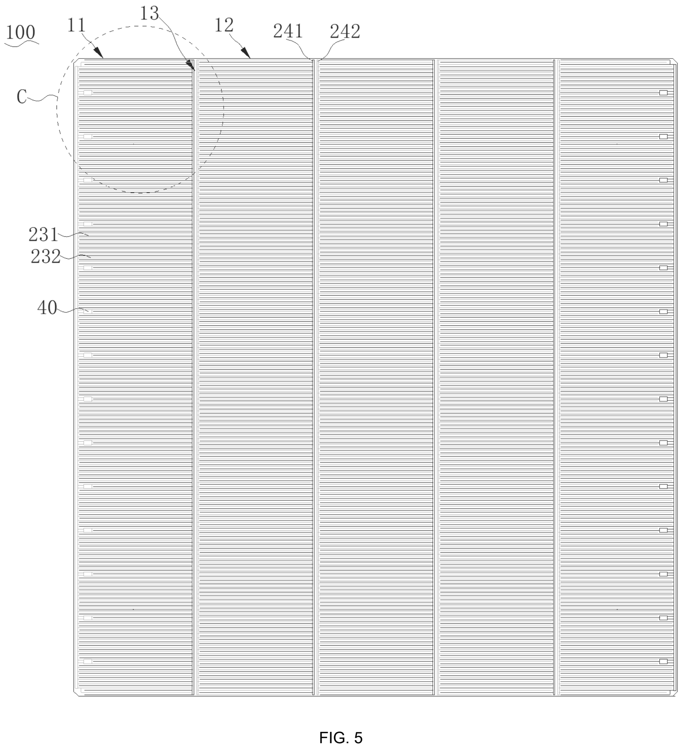

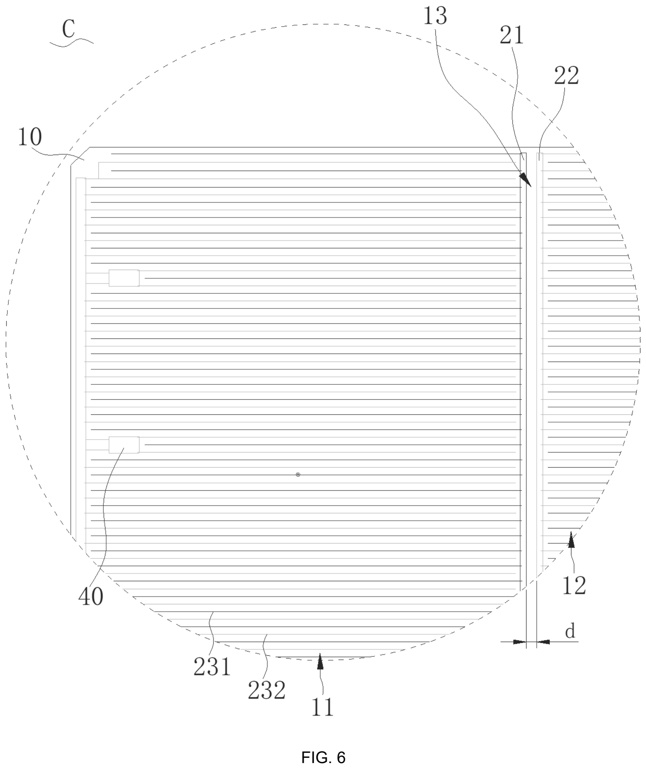

Optionally, the first boundary grid line 21 may be a finger, as shown in FIGS. 1, 2, 3, and 4. The first boundary grid line 21 may be a busbar, as shown in FIGS. 5 and 6.

Optionally, the first boundary grid line 21 may be a straight line, a broken line, a curve, an arc, or another form of line. In this embodiment, the first boundary grid line 21 is illustrated as a straight line for example. This does not limit the specific shape of the first boundary grid line 21.

Optionally, in a case where the first boundary grid line 21 is a straight line, a length direction of the first boundary grid line 21 may be parallel to a length direction of the fingers, as shown in FIGS. 1, 2, 3, and 4. The length direction of the first boundary grid line 21 may be perpendicular to the length direction of the fingers, as shown in FIGS. 5 and 6. It can be understood that, in other examples, the length direction of the first boundary grid line 21 may form an acute angle or an obtuse angle with the length direction of the fingers. The specific length direction of the first boundary grid line 21 is not limited herein.

Optionally, the second boundary grid line 22 refers to a grid line of the electrode structure in the second electrode region 12 closest to the non-electrode region 13. In other words, the second boundary grid line 22 is a boundary line of the second electrode region 12 and also a boundary line between the second electrode region 12 and the non-electrode region 13.

Optionally, the first boundary grid line 21 and the second boundary grid line 22 are parallel to each other. In this way, the non-electrode region 13 has a more regular shape, which facilitates the manufacturing of the electrode regions on two sides and improves the manufacturing efficiency. It can be understood that the first boundary grid line 21 and the second boundary grid line 22 do not have to be parallel. That is, the length direction of the first boundary grid line 21 may intersect the length direction of the second boundary grid line 22.

It should be noted that the second boundary grid line 22 is similar to the first boundary grid line 21. Explanations and descriptions of the second boundary grid line 22 can refer to the explanations and descriptions of the first boundary grid line 21. To avoid redundancy, further details are not repeated herein.

It can be understood that a region between the first boundary grid line 21 and the second boundary grid line 22 is the non-electrode region 13.

Optionally, the first boundary grid line 21 and the second boundary grid line 22 have opposite polarities. This can mean that the first boundary grid line 21 has a negative polarity and the second boundary grid line 22 has a positive polarity, or that the first boundary grid line 21 has a positive polarity and the second boundary grid line 22 has a negative polarity.

Optionally, a disconnection portion of the first boundary grid line 21 may be located at a middle portion and/or an end portion of the first boundary grid line 21. A disconnection portion of the second boundary grid line 22 may be located at a middle portion and/or an end portion of the second boundary grid line 22. The disconnection portion of the first boundary grid line 21 and the disconnection portion of the second boundary grid line 22 can be fully aligned, partially overlapping, or fully offset.

Optionally, the disconnection rate refers to a ratio of a length of a disconnection portion of a boundary grid line to a total length of the boundary grid line. In other words, the disconnection rate of the first boundary grid line 21 refers to a ratio of the length of the disconnection portion of the first boundary grid line 21 to the total length of the first boundary grid line 21. The disconnection rate of the second boundary grid line 22 refers to a ratio of the length of the disconnection portion of the second boundary grid line 22 to the total length of the second boundary grid line 22.

Optionally, the disconnection rate of the first boundary grid line 21 is, for example, 5%, 4.8%, 4%, 2%, 1%, 0.1%, or 0%.

Optionally, the disconnection rate of the second boundary grid line 22 is, for example, 5%, 4.8%, 4%, 2%, 1%, 0.1%, or 0%.

Optionally, the disconnection rate of the first boundary grid line 21 may be the same as or different from the disconnection rate of the second boundary grid line 22.

Referring to FIGS. 1, 2, 5, 6, and 9, the back-contact cell 100 may further include a pad 40 and an electrical connecting member 200. The electrical connecting member 200 is configured to connect the pads 40 of two adjacent back-contact cells 100. In this way, connection between two adjacent back-contact cells 100 can be conveniently achieved, which is beneficial for improving efficiency of manufacturing a cell string. Further, the electrical connecting member 200 can be a conductive wire, a solder ribbon, or the like. The specific form of the electrical connecting member 200 is not limited herein.

### Embodiment 2

Referring to FIGS. 1, 2, 3, 4, 5, and 6, in some embodiments, the disconnection rates of both the first boundary grid line 21 and the second boundary grid line 22 are 0%. The first boundary grid line 21 and the second boundary grid line 22 are continuously arranged on two sides of the non-electrode region 13.

In this way, the potential difference of the non-electrode region 13 can be kept as close to zero as possible. Accordingly, without physically slicing the non-electrode region 13, regions on two sides of the non-electrode region 13 can independently operate in a state similar to that of sliced cells. This achieves an effect equivalent to physically cutting the non-electrode region 13 and maximizes the independent operation of regions on two sides of the non-electrode region 13.

It can be understood that a disconnection rate of 0% for the first boundary grid line 21 means that the first boundary grid line 21 is continuously arranged without any disconnection. A disconnection rate of 0% for the second boundary grid line 22 means that the second boundary grid line 22 is continuously arranged without any disconnection.

It can be understood that, in a case where the first boundary grid line 21 and the second boundary grid line 22 have opposite polarities and are not continuously arranged, the disconnection portions of the boundary grid lines cannot intercept current from the fingers. This causes leakage and prevents the potential difference from approaching zero, and regions on two sides of the non-electrode region 13 can only operate independently by physically slicing the non-electrode region 13. Even if the disconnection rates of both the first boundary grid line 21 and the second boundary grid line 22 are 0%, and the polarities of the first boundary grid line 21 and the second boundary grid line 22 are not opposite, carriers from one of the boundary grid lines can travel across the surface of the silicon wafer 10 through the non-electrode region 13 directly to the other boundary grid line without passing through the PN junction inside the silicon wafer 10. This causes severe leakage, and the regions on two sides of the non-electrode region 13 can again only operate independently by physically slicing the non-electrode region 13.

### Embodiment 3

Referring to FIGS. 1, 2, 3, 4, 5, and 6, in some embodiments, a width d of the non-electrode region 13 is 0.05 mm to 1.0 mm. For example, the width d of the non-electrode region 13 may be 0.05 mmmm, 0.06 mmm, 0.1 mm, 0.5 mm, 0.7 mm, 0.8 mm, 0.9 mm, or 1 mm.

In this way, the width d of the non-electrode region 13 is within a suitable range. This avoids a significant reduction in current-intercepting effectiveness of two boundary grid lines caused by excessively small width d of the non-electrode region 13, and also avoids waste of a power generation area caused by excessively large width d of the non-electrode region 13.

Preferably, the width d of the non-electrode region 13 is 0.6 mm to 0.8 mm. For example, the width d of the non-electrode region 13 may be 0.6 mm, 0.62 mm, 0.65 mm, 0.67 mm, 0.7 mm, 0.75 mm, 0.78 mm, or 0.8 mm. In this way, the width d of the non-electrode region 13 is further optimized, and a balance between current-intercepting performance of the boundary grid lines and effective utilization of the power generation area is achieved, thereby providing an improved overall performance.

### Embodiment 4

In some embodiments, a width of the first boundary grid line 21 is 10 µm to 1.5 mm. For example, the width of the first boundary grid line 21 may be 10 µm, 12 µm, 50 µm, 100 µm, 300 µm, 500 µm, 800 µm, 1 mm, 1.2 mm, or 1.5 mm.

In this way, the width of the first boundary grid line 21 is within a suitable range. This avoids excessive process difficulty or infeasibility caused by excessively small width, and avoids grid line breakage caused by excessively small width. This also avoids material waste and excessively high cost caused by excessively large width.

Preferably, the width of the first boundary grid line 21 is 800 µm to 1000 µm. For example, the width of the first boundary grid line 21 may be 800 µm, 810 µm, 850 µm, 880 µm, 900 µm, 980 µm, or 1000 µm. In this way, the width of the first boundary grid line 21 is further optimized, and a balance among process feasibility, grid line quality, and cost is achieved, thereby providing an improved overall performance.

### Embodiment 5

In some embodiments, a thickness of the first boundary grid line 21 is 1 µm to 20 µm. For example, the thickness of the first boundary grid line 21 may be 1 µm, 2 µm, 5 µm, 8 µm, 10 µm, 12 µm, 15 µm, 18 µm, or 20 µm.

In this way, the thickness of the first boundary grid line 21 is within a suitable range. This avoids excessive process difficulty or infeasibility caused by excessively small thickness, and also avoids material waste and excessively high cost caused by excessively large thickness.

Preferably, the thickness of the first boundary grid line 21 is 9 µm to 11 µm. For example, the thickness of the first boundary grid line 21 may be 9 µm, 9.2 µm, 9.5 µm, 10 µm, 10.3 µm, 10.5 µm, 10.8 µm, or 11 µm. In this way, the thickness of the first boundary grid line 21 is further optimized, and a balance between process feasibility and cost is achieved, thereby providing an improved overall performance.

### Embodiment 6

In some embodiments, a width of the second boundary grid line 22 is 10 µm to 1.5 mm. For example, the width of the second boundary grid line 22 may be 10 µm, 12 µm, 50 µm, 100 µm, 300 µm, 500 µm, 800 µm, 1 mm, 1.2 mm, or 1.5 mm.

In this way, the width of the second boundary grid line 22 is within a suitable range. This avoids excessive process difficulty or infeasibility caused by excessively small width, and avoids grid line breakage caused by excessively small width. This also avoids material waste and excessively high cost caused by excessively large width.

Preferably, the width of the second boundary grid line 22 is 800 µm to 1000 µm. For example, the width of the second boundary grid line 22 may be 800 µm, 810 µm, 850 µm, 880 µm, 900 µm, 980 µm, or 1000 µm. In this way, the width of the second boundary grid line 22 is further optimized, and a balance among process feasibility, grid line quality, and cost is achieved, thereby providing an improved overall performance.

### Embodiment 7

In some embodiments, a thickness of the second boundary grid line 22 is 1 µm to 20 µm. For example, the thickness of the second boundary grid line 22 may be 1 µm, 2 µm, 5 µm, 8 µm, 10 µm, 12 µm, 15 µm, 18 µm, or 20 µm.

In this way, the thickness of the second boundary grid line 22 is within a suitable range. This avoids excessive process difficulty or infeasibility caused by excessively small thickness, and also avoids material waste and excessively high cost caused by excessively large thickness.

Preferably, the thickness of the second boundary grid line 22 is 9 µm to 11 µm. For example, the thickness of the second boundary grid line 22 may be 9 µm, 9.2 µm, 9.5 µm, 10 µm, 10.3 µm, 10.5 µm, 10.8 µm, or 11 µm. In this way, the thickness of the second boundary grid line 22 is further optimized, and a balance between process feasibility and cost is achieved, thereby providing an improved overall performance.

### Embodiment 8

In some embodiments, an offset distance between end portions of the first boundary grid line 21 and the second boundary grid line 22 is less than or equal to 3 mm. For example, the offset distance may be 3 mm, 2.8 mm, 2.5 mm, 2 mm, 1.5 mm, 1 mm, or 0.1 mm.

In this way, the offset distance between the end portions of the first boundary grid line 21 and the second boundary grid line 22 is within a suitable range. This avoids an excessive amount of finger current that cannot be intercepted due to an excessively large offset distance, which would otherwise cause increased leakage and prevent the potential difference from being reduced as much as possible. In this case, the regions on two sides of the non-electrode region 13 can only operate independently by physically slicing the non-electrode region 13.

Optionally, the offset distance refers to a distance by which one boundary grid line extends beyond the other boundary grid line in a width direction of the boundary grid line itself. That is, the offset distance refers to a distance by which the first boundary grid line 21 extends beyond the second boundary grid line 22 in a width direction of the first boundary grid line 21, or a distance by which the second boundary grid line 22 extends beyond the first boundary grid line 21 in a width direction of the second boundary grid line 22.

### Embodiment 9

In some embodiments, an offset distance between end portions of the first boundary grid line 21 and the second boundary grid line 22 is 0 mm, and an end portion of the first boundary grid line 21 is fully aligned with an end portion of the second boundary grid line 22.

In this way, end portions of the first boundary grid line 21 are fully aligned with end portions of the second boundary grid line 22 in a width direction. The first boundary grid line 21 does not extend beyond the second boundary grid line 22, and the second boundary grid line 22 does not extend beyond the first boundary grid line 21. Accordingly, finger current can be intercepted to the greatest extent, leakage risk is reduced, and the potential difference can be reduced as much as possible. As a result, the regions on two sides of the non-electrode region 13 can operate independently without physically slicing the non-electrode region 13.

### Embodiment 10

Referring to FIGS. 1, 2, 3, and 4, in some embodiments, the first boundary grid line 21 and the second boundary grid line 22 extend along a first direction of the silicon wafer 10, and the first electrode region 11 and the second electrode region 12 are spaced apart along a second direction of the silicon wafer 10, where the second direction intersects the first direction.

The first boundary grid line 21 is a finger located at an end portion of an electrode structure of the first electrode region 11 close to the non-electrode region 13. The second boundary grid line 22 is a finger located at an end portion of an electrode structure of the second electrode region 12 close to the non-electrode region 13.

In this way, both the first boundary grid line 21 and the second boundary grid line 22 are fingers, and an arrangement direction of the first electrode region 11 and the second electrode region 12 intersects a length direction of the fingers. With positional cooperation between the boundary grid lines and the electrode regions, an arrangement is relatively regular, which is beneficial for improving manufacturing efficiency.

Optionally, the first direction is a length direction of the fingers. The second direction is a direction intersecting the length direction of the fingers.

In this embodiment, the second direction is perpendicular to the length direction of the fingers. In this way, the arrangement of the boundary grid lines and the electrode regions is more regular, which enables full utilization of space of the silicon wafer 10. It can be understood that, in other embodiments, the second direction can form an acute angle or an obtuse angle with the length direction of the fingers.

### Embodiment 11

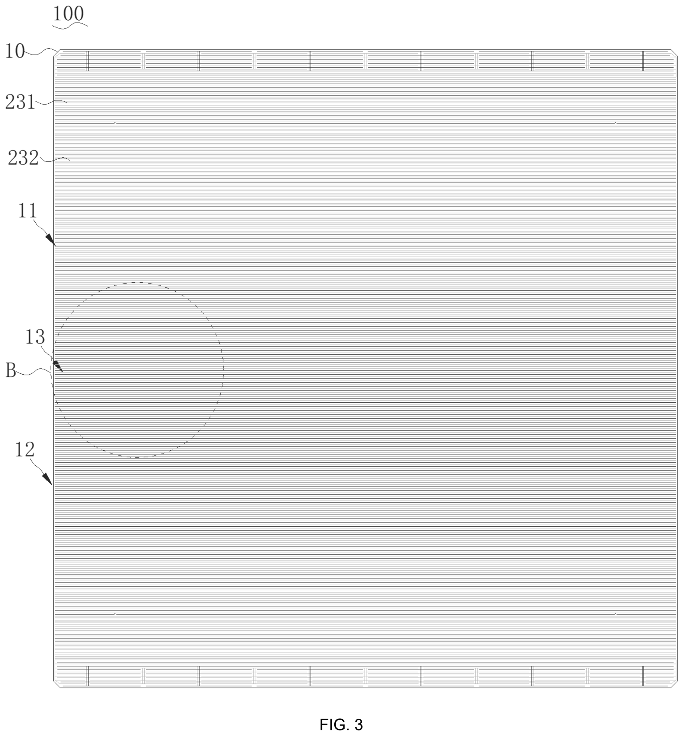

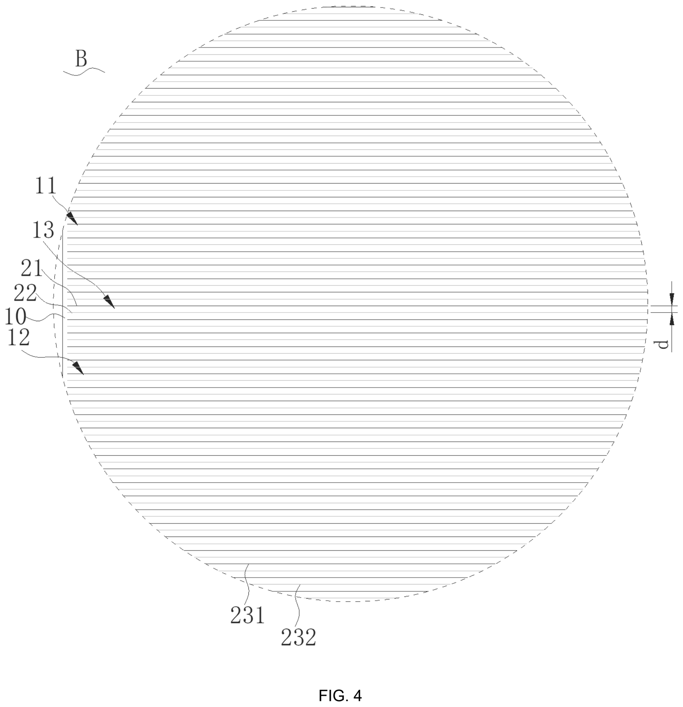

Referring to FIGS. 3 and 4, in some embodiments, the back-contact cell 100 is a busbar-less cell, and the electrode structure includes a plurality of first fingers 231 and a plurality of second fingers 232. The plurality of first fingers 231 and the plurality of second fingers 232 are alternately arranged and spaced along a second direction of the silicon wafer 10.

In this way, the back-contact cell 100 does not require a busbar, which can reduce consumption of electrode paste and is beneficial for lowering cost.

Optionally, the first finger 231 and the second finger 232 have opposite polarities. In other words, in a case where the first finger 231 has a positive polarity, the second finger 232 has a negative polarity; and in a case where the first finger 231 has a negative polarity, the second finger 232 has a positive polarity.

Optionally, one, two, three, or other numbers of the first fingers 231 may be provided. One, two, three, or other numbers of the second fingers 232 may be provided. The number of the first fingers 231 may be the same as or different from the number of the second fingers 232.

Optionally, the plurality of first fingers 231 and the plurality of second fingers 232 are alternately arranged along a second direction of the silicon wafer 10. This means that a second finger 232 is disposed between two adjacent first fingers 231, and a first finger 231 is disposed between two adjacent second fingers 232.

Optionally, the plurality of first fingers 231 and the plurality of second fingers 232 are sequentially spaced along the second direction of the silicon wafer 10. This means that a gap is formed between the first finger 231 and the second finger 232 adjacent to each other.

### Embodiment 12

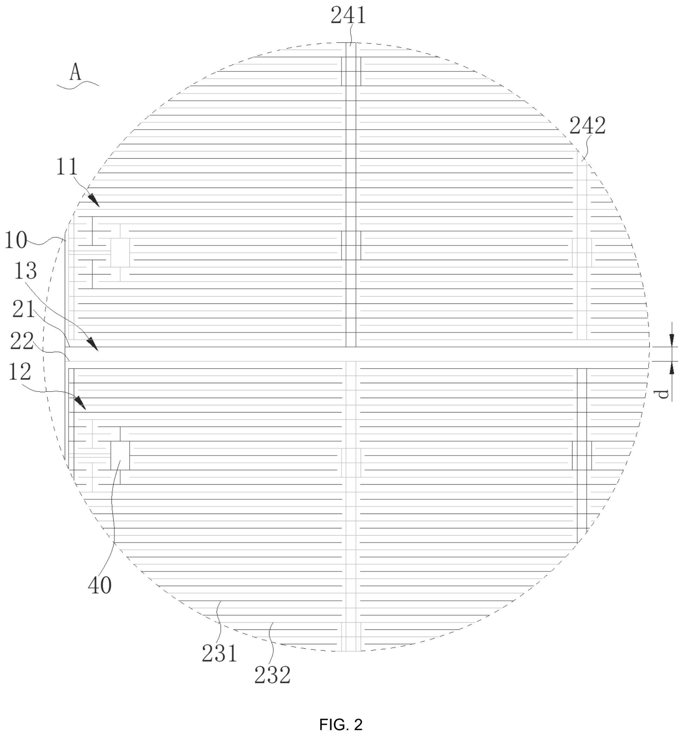

Referring to FIGS. 1 and 2, in some embodiments, the electrode structure includes:
a plurality of first fingers 231 and a plurality of second fingers 232, where the plurality of first fingers 231 and the plurality of second fingers 232 are alternately arranged and spaced along a second direction of the silicon wafer 10; and
a plurality of first busbars 241 and a plurality of second busbars 242, where the plurality of first busbars 241 and the plurality of second busbars 242 are alternately arranged and spaced along a first direction, each first busbar 241 is connected to all first fingers 231 in the electrode structure, and each second busbar 242 is connected to all second fingers 232 in the electrode structure.

In this way, the back-contact cell 100 includes busbars, and the busbars can collect current from the fingers and deliver the current to the outside of the cell via conductive members 30 such as solder ribbons, resulting in improved current extraction. Moreover, the busbar generally has a relatively large grid line width, which facilitates connection with the conductive member 30 such as a solder ribbon and is beneficial for improving manufacturing efficiency.

Explanations and descriptions of the first finger 231 and the second finger 232 can be referred to the foregoing descriptions. To avoid redundancy, further details are not repeated herein.

Optionally, the first busbars 241 and the second busbars 242 have opposite polarities. In other words, in a case where the first busbar 241 has a positive polarity, the second busbar 242 has a negative polarity; and in a case where the first busbar 241 has a negative polarity, the second busbar 242 has a positive polarity.

Optionally, one, two, three, or other numbers of the first busbars 241 may be provided. One, two, three, or other numbers of the second busbars 242 may be provided. The number of the first busbars 241 may be the same as or different from the number of the second busbars 242.

Optionally, the plurality of first busbars 241 and the plurality of second busbars 242 are alternately arranged along the first direction of the silicon wafer 10. This means that a second busbar 242 is disposed between two adjacent first busbars 241, and a first busbar 241 is disposed between two adjacent second busbars 242.

Optionally, the plurality of first busbars 241 and the plurality of second busbars 242 are sequentially spaced along the second direction of the silicon wafer 10. This means that a gap is formed between the first busbar 241 and the second busbar 242 adjacent to each other.

### Embodiment 13

Referring to FIGS. 1 and 2, in some embodiments, the first busbar 241 of the electrode structure in the first electrode region 11 is aligned in the second direction with the second busbar 242 of the electrode structure in the second electrode region 12; and
the second busbar 242 of the electrode structure in the first electrode region 11 is aligned in the second direction with the first busbar 241 of the electrode structure in the second electrode region 12.

In this way, busbars having opposite polarities of the electrode structure in the first electrode region 11 and the second electrode region 12 are aligned along the length direction of the busbars, which facilitates subsequent connection of the busbars having opposite polarities in the two electrode regions with solder ribbons, and improves the manufacturing efficiency of the cell string.

Optionally, the first busbar 241 of the electrode structure in the first electrode region 11 is aligned with the second busbar 242 of the electrode structure in the second electrode region 12 in the second direction, which means that a projection of the first busbar 241 in the first electrode region 11 and a projection of the second busbar 242 in the second electrode region 12 overlap in the same plane along the second direction. Similarly, the second busbar 242 of the electrode structure in the first electrode region 11 is aligned with the first busbar 241 of the electrode structure in the second electrode region 12 in the second direction, which means that a projection of the second busbar 242 in the first electrode region 11 and a projection of the first busbar 241 in the second electrode region 12 overlap in the same plane along the second direction.

Further, a centerline of the first busbar 241 of the electrode structure in the first electrode region 11 is aligned on the same straight line with a centerline of the second busbar 242 of the electrode structure in the second electrode region 12. Similarly, a centerline of the second busbar 242 of the electrode structure in the first electrode region 11 is aligned on the same straight line with a centerline of the first busbar 241 of the electrode structure in the second electrode region 12. This ensures that the centerlines of the busbars having opposite polarities in the electrode structures of the two electrode regions are in the same straight line, allowing more precise alignment and further facilitating subsequent soldering.

Furthermore, the first busbar 241 of the electrode structure in the first electrode region 11 and the second busbar 242 of the electrode structure in the second electrode region 12 have the same width. In other words, a projection of the first busbar 241 in the first electrode region 11 and a projection of the second busbar 242 in the second electrode region 12 fully overlap in the same plane along the second direction. In this way, the busbars having opposite polarities in the electrode structures of the two electrode regions are fully aligned along the second direction, which maximizes alignment accuracy and further facilitates subsequent soldering.

### Embodiment 14

Referring to FIGS. 5 and 6, in some embodiments, the first electrode region 11 and the second electrode region 12 are spaced along a first direction of the silicon wafer 10, the first boundary grid line 21 and the second boundary grid line 22 extend along a second direction of the silicon wafer 10, and the second direction intersects the first direction. The first boundary grid line 21 is a busbar located at an end portion of the electrode structure in the first electrode region 11 close to the non-electrode region 13, and the second boundary grid line 22 is a busbar located at an end portion of the electrode structure in the second electrode region 12 close to the non-electrode region 13.

In this way, both the first boundary grid line 21 and the second boundary grid line 22 are busbars, and an arrangement direction of the first electrode region 11 and the second electrode region 12 intersects a length direction of the busbars. With positional cooperation between the boundary grid lines and the electrode regions, an arrangement is relatively regular, which is beneficial for improving manufacturing efficiency.

Optionally, the second direction is a length direction of the busbars. The first direction is a direction intersecting the length direction of the busbars.

In this embodiment, the first direction is perpendicular to the length direction of the busbars. In this way, the arrangement of the boundary grid lines and the electrode regions is more regular, which enables full utilization of space of the silicon wafer 10. It can be understood that, in other embodiments, the first direction can form an acute angle or an obtuse angle with the length direction of the busbars.

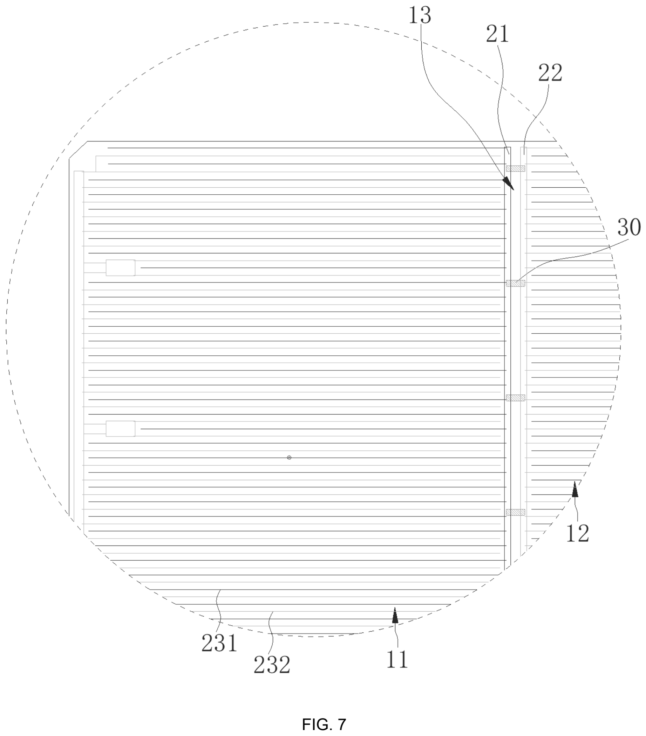

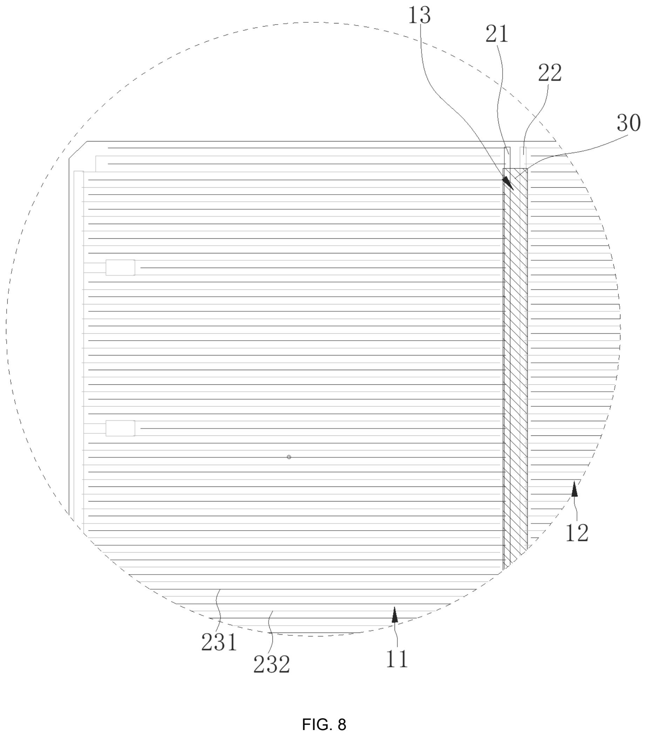

Referring to FIGS. 7 and 8, the back-contact cell 100 may further include a conductive member 30, and the conductive member 30 is configured to electrically connect the first boundary grid line 21 and the second boundary grid line 22 adjacent to each other. In this way, busbars having opposite polarities located on two sides of the non-electrode region 13 can be efficiently electrically connected, thereby achieving a connection of electrode structures in which the two electrode regions operate independently.

Further, the conductive member 30 may be formed by curing a conductive material, as shown in FIG. 7. The conductive material may include, for example, tin paste or conductive adhesive. Furthermore, a plurality of conductive members 30 may be provided, and a spacing between two adjacent conductive members 30 is less than or equal to 30 mm. For example, the spacing may be 30 mm, 28 mm, 25 mm, 20 mm, 18 mm, 10 mm, 5 mm, or 1 mm. In this way, the spacing between two adjacent conductive members 30 is within a suitable range, which can prevent deterioration of the electrical connection effect of the busbars having opposite polarities caused by excessive spacing. Furthermore, a width of the conductive member 30 is 0.5 mm to 2 mm. For example, the width may be 0.5 mm, 0.8 mm, 1 mm, 1.2 mm, 1.5 mm, 1.8 mm, or 2 mm. The width of the conductive member 30 refers to a dimension of the conductive member 30 in the length direction of the boundary grid line. In this way, the width of the conductive member 30 is within a suitable range, so that breakage or difficulty in manufacturing caused by excessively small width can be avoided, and material waste and increased cost caused by excessively large width can also be avoided.

Further, the conductive member 30 may include a solder ribbon, as shown in FIG. 8. A length direction of the solder ribbon is parallel to a length direction of the boundary grid line. In this way, busbars having opposite polarities located on two sides of the non-electrode region 13 can be efficiently electrically connected, which is beneficial for improving the manufacturing efficiency of a cell string.

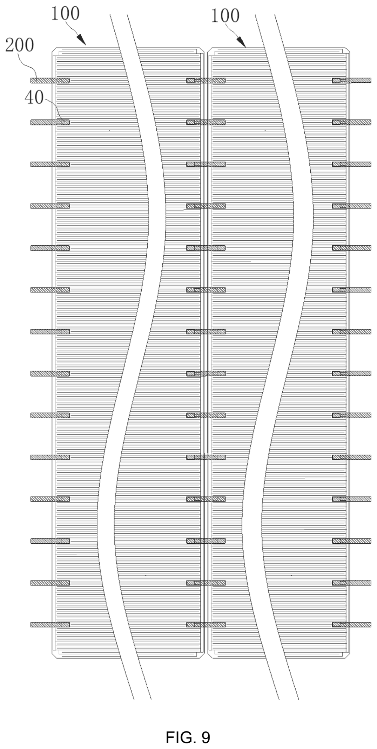

Referring to FIG. 9, the back-contact cell 100 may further include a pad 40 and an electrical connecting member 200. The electrical connecting member 200 is configured to connect the pads 40 of two adjacent back-contact cells 100. In this way, connection between two adjacent back-contact cells 100 can be conveniently achieved, which is beneficial for improving efficiency of manufacturing a cell string. Further, the electrical connecting member 200 can be a conductive wire, a solder ribbon, or the like. The specific form of the electrical connecting member 200 is not limited herein.

### Embodiment 15

Referring to FIGS. 5 and 6, in some embodiments, the electrode structure includes:
a plurality of first fingers 231 and a plurality of second fingers 232, where the plurality of first fingers 231 and the plurality of second fingers 232 are alternately arranged and spaced along a second direction of the silicon wafer 10; and
a first busbar 241 and a second busbar 242, where the first busbar 241 and the second busbar 242 are spaced along a first direction, the first busbar 241 is located on one side of the first finger 231 and the second finger 232 and connected to end portions of all the first fingers 231, and the second busbar 242 is located on the other side of the first finger 231 and the second finger 232 and connected to end portions of all the second fingers 232; and
a non-electrode region 13 is formed between the first busbar 241 and the second busbar 242 adjacent to each other.

In this way, by using busbars having opposite polarities as the boundary grid lines and forming the non-electrode region 13 between the busbars having opposite polarities, the breakage of the boundary grid lines caused by excessively small width can be avoided, thereby ensuring the effect of the boundary grid lines in intercepting current. Moreover, when the electrode structures of the first electrode region 11 and the second electrode region 12 are connected, the conductive member 30 only needs to be disposed between boundary grid lines having opposite polarities on two sides of the non-electrode region 13, which is simple and convenient.

Explanations and descriptions of the first finger 231, the second finger 232, the first busbar 241, and the second busbar 242 can be referred to the foregoing descriptions. To avoid redundancy, further details are not repeated herein.

### Embodiment 16

A cell assembly according to an embodiment of the present application includes the back-contact cell 100 according to any one of Embodiments 1 to 15.

According to the cell assembly in the embodiment of the present application, since the boundary grid lines of the two electrode structures in the back-contact cell 100 have opposite polarities and disconnection rates of the two electrode structures are less than or equal to 5%, a potential difference of the non-electrode region 13 can be kept as low as possible. Accordingly, without physically cutting the non-electrode region 13, regions on two sides of the non-electrode region 13 can independently operate in a state close to that of sliced cells, thereby achieving an effect similar to that of physically cutting the non-electrode region 13. In this way, an effect similar to slicing is achieved, the slicing step and slicing device can be omitted, thereby reducing costs.

In this embodiment, a plurality of back-contact cells 100 in the cell assembly may be sequentially connected in series to form a cell string, thereby achieving series output. For example, the series connection of the cells may be achieved by providing solder ribbons (bus ribbons or interconnection ribbons), a conductive backsheet, or the like.

It can be understood that, in such an embodiment, the cell assembly may further include a metal frame, a backsheet, photovoltaic glass, and an encapsulant. The encapsulant may be filled between the front and back surfaces of the back-contact cell 100, the photovoltaic glass, adjacent cells, and the like, serving as a filler. The encapsulant can be a transparent polymer with good light transmittance and aging resistance. For example, the encapsulant can be an EVA film or a POE film. The specific selection can be made according to actual conditions. This is not limited herein.

The photovoltaic glass can cover the encapsulant on the front surface of the back-contact cell 100. The photovoltaic glass can be ultra-clear glass, which has high light transmittance, high transparency, and superior physical, mechanical, and optical properties. For example, the transmittance of ultra-clear glass can reach 92% or more, allowing the back-contact cell 100 to be protected without significantly affecting the efficiency of the back-contact cell 100. Meanwhile, the encapsulant can bond the photovoltaic glass and the back-contact cell 100 together. The presence of the encapsulant can provide sealing, insulation, and protection against water and moisture for the back-contact cell 100.

The backsheet can be attached to the encapsulant on the back surface of the back-contact cell 100. The backsheet can provide protection and support for the back-contact cell 100, exhibiting reliable insulation, water resistance, and aging resistance. The backsheet can typically be selected from tempered glass, organic glass, aluminum alloy TPT composite films, or the like. The specific selection can be made according to actual conditions, and is not limited herein. The assembly of the backsheet, the back-contact cell 100, the encapsulant, and the photovoltaic glass can be disposed on a metal frame. The metal frame serves as the main external support structure of the cell assembly, providing stable support and installation. For example, the cell assembly can be installed at a desired location via the metal frame.

### Embodiment 17

A photovoltaic system according to an embodiment of the present application includes the cell assembly according to Embodiment 16.

According to the photovoltaic system in the embodiment of the present application, since the boundary grid lines of the two electrode structures in the back-contact cell 100 have opposite polarities and disconnection rates of the two electrode structures are less than or equal to 5%, a potential difference of the non-electrode region 13 can be kept as low as possible. Accordingly, without physically cutting the non-electrode region 13, regions on two sides of the non-electrode region 13 can independently operate in a state close to that of sliced cells, thereby achieving an effect similar to that of physically cutting the non-electrode region 13. In this way, an effect similar to slicing is achieved, the slicing step and slicing device can be omitted, thereby reducing costs.

In this embodiment, the photovoltaic system may be applied in photovoltaic power stations, such as ground-mounted power stations, rooftop power stations, and floating power stations, and can also be applied in devices or equipment utilizing solar energy for power generation, such as user solar power supplies, solar street lights, solar vehicles, and solar buildings. Of course, it can be understood that the application scenarios of the photovoltaic system are not limited to the foregoing. That is, the photovoltaic system can be applied in all fields requiring solar energy for power generation. Taking a photovoltaic power generation system grid as an example, the photovoltaic system can include a photovoltaic array, a combiner box, and an inverter. The photovoltaic array can be an array combination of a plurality of cell assemblies. For example, a plurality of cell assemblies can form a plurality of photovoltaic arrays. The photovoltaic arrays are connected to the combiner box, and the combiner box collects the currents generated by the photovoltaic arrays. The combined current then passes through the inverter to be converted into alternating current meeting the requirements of the utility grid, and is connected to the utility network to realize solar power supply.

In the description of the specification, the reference terms "some embodiments", "illustrative embodiments", "examples", "specific examples", or "some examples" refer to the specific features, structures, materials, or characteristics described in conjunction with the embodiments or examples included in at least one embodiment or example of the present application. The schematic expressions of the above terms in the specification do not necessarily refer to the same embodiments or examples. Moreover, the specific features, structures, materials, or characteristics described can be combined in a suitable manner in any one or more embodiments or examples.

In addition, the above are only preferred embodiments of the present application and are not intended to limit the present application. Any modifications, equivalent substitutions, and improvements made within the spirit and principles of the present application shall be included in the scope of protection of the present application.

## Claims

1. A back-contact cell, comprising a silicon wafer and a plurality of electrode structures, wherein a first electrode region, a second electrode region, and a non-electrode region are formed on a back surface of the silicon wafer, the non-electrode region is located between the first electrode region and the second electrode region, an electrode structure located in the first electrode region comprises a first boundary grid line, an electrode structure located in the second electrode region comprises a second boundary grid line, the first boundary grid line and the second boundary grid line have opposite polarities, and disconnection rates of both the first boundary grid line and the second boundary grid line are less than or equal to 5%.

2. The back-contact cell according to claim 1, wherein the disconnection rates of both the first boundary grid line and the second boundary grid line are 0%, and the first boundary grid line and the second boundary grid line are continuously arranged on two sides of the non-electrode region.

3. The back-contact cell according to claim 1, wherein a width of the non-electrode region is 0.05 mm to 1.0 mm.

4. The back-contact cell according to claim 1, wherein a width of the first boundary grid line is 10 µm to 1.5 mm.

5. The back-contact cell according to claim 1, wherein a thickness of the first boundary grid line is 1 µm to 20 µm.

6. The back-contact cell according to claim 1, wherein a width of the second boundary grid line is 10 µm to 1.5 mm.

7. The back-contact cell according to claim 1, wherein a thickness of the second boundary grid line is 1 µm to 20 µm.

8. The back-contact cell according to claim 1, wherein an offset distance between end portions of the first boundary grid line and the second boundary grid line is less than or equal to 3 mm.

9. The back-contact cell according to claim 8, wherein the offset distance between end portions of the first boundary grid line and the second boundary grid line is 0 mm, and an end portion of the first boundary grid line is fully aligned with an end portion of the second boundary grid line.

10. The back-contact cell according to claim 1, wherein the first boundary grid line and the second boundary grid line extend along a first direction of the silicon wafer, and the first electrode region and the second electrode region are spaced apart along a second direction of the silicon wafer, wherein the second direction intersects the first direction;
the first boundary grid line is a finger located at an end portion of the electrode structure of the first electrode region close to the non-electrode region; and the second boundary grid line is a finger located at an end portion of the electrode structure of the second electrode region close to the non-electrode region.

11. The back-contact cell according to claim 10, wherein the back-contact cell is a busbar-less cell, the electrode structure comprises a plurality of first fingers and a plurality of second fingers, and the plurality of first fingers and the plurality of second fingers are alternately arranged and spaced along the second direction of the silicon wafer.

12. The back-contact cell according to claim 10, wherein the electrode structure comprises:
a plurality of first fingers and a plurality of second fingers, wherein the plurality of first fingers and the plurality of second fingers are alternately arranged and spaced along the second direction of the silicon wafer; and
a plurality of first busbars and a plurality of second busbars, wherein the plurality of first busbars and the plurality of second busbars are alternately arranged and spaced along the first direction, each first busbar is connected to all first fingers in the electrode structure, and each second busbar is connected to all second fingers in the electrode structure.

13. The back-contact cell according to claim 12, wherein the first busbar of the electrode structure in the first electrode region is aligned in the second direction with the second busbar of the electrode structure in the second electrode region; and
the second busbar of the electrode structure in the first electrode region is aligned in the second direction with the first busbar of the electrode structure in the second electrode region.

14. The back-contact cell according to claim 1, wherein the first electrode region and the second electrode region are spaced along a first direction of the silicon wafer, the first boundary grid line and the second boundary grid line extend along a second direction of the silicon wafer, the second direction intersects the first direction, the first boundary grid line is a busbar located at an end portion of the electrode structure in the first electrode region close to the non-electrode region, and the second boundary grid line is a busbar located at an end portion of the electrode structure in the second electrode region close to the non-electrode region.

15. **The** back-contact cell according to claim 14, wherein the electrode structure comprises:
a plurality of first fingers and a plurality of second fingers, wherein the plurality of first fingers and the plurality of second fingers are alternately arranged and spaced along the second direction of the silicon wafer; and
a first busbar and a second busbar, wherein the first busbar and the second busbar are spaced along the first direction, the first busbar is located on one side of the first finger and the second finger and connected to end portions of all the first fingers, and the second busbar is located on the other side of the first finger and the second finger and connected to end portions of all the second fingers; and
the non-electrode region is formed between the first busbar and the second busbar adjacent to each other.

16. A cell assembly, comprising the back-contact cell according to any one of claims 1 to 15.

17. A photovoltaic system, comprising the cell assembly according to claim 16.
